(19) Europäisches Patentamt / European Patent Office / Office européen des brevets

(11) **EP 4 664 127 A1**

(12) **EUROPEAN PATENT APPLICATION**

(43) Date of publication:
**17.12.2025   Bulletin 2025/51**

(21) Application number: **25181743.3**

(22) Date of filing: **10.06.2025**

(51) International Patent Classification (IPC):
**G01R 31/34** (2020.01)      **G01R 31/52** (2020.01)
**G01R 31/72** (2020.01)

(52) Cooperative Patent Classification (CPC):
**G01R 31/346; G01R 31/52; G01R 31/72**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.06.2024   IN 202411044635**

(71) Applicant: **Eaton Intelligent Power Limited**
**D04 Y0C2 Dublin 4 (IE)**

(72) Inventors:
• **Singh, Gurmeet**
  **Dublin 4, D04 Y0C2 (IE)**
• **Satsai, Srinivas Mallampalli**
  **Dublin 4, D04 Y0C2 (IE)**
• **Goramane, Shashirekha A**
  **Dublin 4, D04 Y0C2 (IE)**
• **Naikawadi, Komal Madan**
  **Dublin 4, D04 Y0C2 (IE)**

(74) Representative: **Derry, Paul Stefan et al**
**Venner Shipley LLP**
**200 Aldersgate**
**London EC1A 4HD (GB)**

(54) **WINDING FAULT DETECTION SYSTEM AND METHOD**

(57)      Winding fault detection system (150) and method is provided. A first instantaneous current in first set of windings of the multi-wound electrical device (100) is received. A second instantaneous current in second set of windings of the multi-wound electrical device (100) is received. First sequence components are determined from the first instantaneous current. Second sequence components are determined from the second instantaneous current. The first sequence components are compared with second sequence components. A winding fault in the multi-wound electrical device (100) is determined when a difference in the first sequence components and second sequence components is greater than a predetermined value.

Fault Detection System
**150**

Motor
**100**

Current Sensors
152

Fault detector
**154**

FIG. 1C

EP 4 664 127 A1

**Description**

**CROSS-REFERENCE TO RELATED APPLICATION**

This application claims priority to Indian Provisional Patent Application No. 202411044635, filed June 10, 2024.

**TECHNICAL FIELD**

The present disclosure relates generally to fault detection, and, more particularly to winding fault detection.

**BACKGROUND**

Winding faults occur when a portion of insulation surrounding individual windings wears down or short circuit occurs between winding conductors. A winding fault in a motor, for example, effectively reduces the number of turns in the affected phase of a multi-phase motor, which can unbalance the motor, reduce the performance of the motor, and/or damage the motor. As such, there is a need to detect winding faults and take precautions in response thereto.

**Summary**

One aspect of the present disclosure provides method for determining a winding fault in a multi-wound electrical device. A first instantaneous current in first set of windings of the multi-wound electrical device is received. A second instantaneous current in second set of windings of the multi-wound electrical device is received. First sequence components are determined from the first instantaneous current. Second sequence components are determined from the second instantaneous current. The first sequence components are compared with second sequence components. A winding fault in the multi-wound electrical device is determined when a difference in the first sequence components and second sequence components is greater than a predetermined value.

In accordance with further aspects of the disclosure, a system for determining a winding fault in a multi-would electrical device, comprising: a memory; and a processor connected to the memory, wherein the processor is configured to: receive a first instantaneous current in first set of windings of the multi-wound electrical device; receive a second instantaneous current in second set of windings of the multi-wound electrical device; determine first sequence components from the first instantaneous current; determine second sequence components from the second instantaneous current; compare the first sequence components with second sequence components; and determine a winding fault in the multi-wound electrical device when a difference in the first sequence components and second sequence components is greater than a predetermined value.

In accordance with still further aspects of the disclosure, a computer-readable medium that stores a set of instructions which when executed perform a method executed by the set of instructions comprising: receiving a first instantaneous current in first set of windings of the multi-wound electrical device; receiving a second instantaneous current in second set of windings of the multi-wound electrical device; determining first sequence components from the first instantaneous current; determining second sequence components from the second instantaneous current; comparing the first sequence components with second sequence components; and determining a winding fault in the multi-wound electrical device when a difference in the first sequence components and second sequence components is greater than a predetermined value.

These and other features and advantages will be apparent from a reading of the following detailed description and a review of the associated drawings. A variety of additional aspects will be set forth in the description that follows. These aspects can relate to individual features and to combinations of features. It is to be understood that both the foregoing general description and the following detailed description are exemplary and explanatory only and are not restrictive of the broad concepts upon which the embodiments disclosed herein are based.

**BRIEF DESCRIPTION OF THE DRAWINGS**

The accompanying drawings which are incorporated in and constitute a part of the description, illustrate several aspects of the disclosure. A brief description of the drawings is as follows:

FIG. 1A is diagram of a sectional representation of an example multi-wound motor in accordance with principles of the present disclosure.

FIG. 1B is a diagram of another sectional representation of the example multi-wound motor of FIG. 1A.

FIG. 1C is a diagram of a system for determining a winding fault.

FIG. 2A is a flow diagram of a method for determining a winding fault.

FIG. 2B is a diagram of a Table 1 illustrating first example measurements corresponding to two windings of a motor.

FIG. 3A is a flow diagram of a method for determining a winding-to-winding (WW) fault.

FIG. 3B is a diagram of a Table 2 illustrating second example measurements corresponding to a phase-to-ground (PG) fault.

FIG. 3C is a diagram of a Table 3 illustrating third example measurements corresponding to a phase-to-phase (PP) fault.

FIG. 3D is a diagram of a Table 4 illustrating fourth example measurements corresponding to a PG fault and a WW fault.

FIG. 4A is a model of a multi-wound motor with a PG fault.

FIG. 4B is a model of a multi-wound motor with a PP fault.

FIG. 5 is a block diagram of a computing device.

## DETAILED DESCRIPTION

Reference will now be made in detail to exemplary aspects of the present disclosure that are illustrated in the accompanying drawings. Wherever possible, the same reference numbers will be used throughout the drawings to refer to the same or like structure.

The disclosure provides techniques to determine winding faults in multi-wound electrical devices (for example, motors, generators, transformers, etc.). In a multi-wound electrical device, following types of winding faults can occur: a phase-to-ground (PG) fault, a phase-to-phase (PP) fault (also referred to as a winding-to-winding (WW) fault), an inter-turn (IT) fault, a phase-to-phase (PP) and a PG fault in both the winding set. The disclosure provides techniques to detect these types of winding faults, and estimate a severity of these winding faults in a multi-wound electrical device. Current sensors are used for detection of these faults. In one example aspects, the winding faults are determined by comparing features of one set of winding with another set of windings of a multi-wound electrical device. Determining winding faults by comparing features of one set of winding are compared with another set of windings mitigates the effect of temperature, load, and other operational and environmental factors on winding fault detection. Aspects of the disclosure further provide techniques to distinguish between a WW fault and a PG fault in two windings. In addition, aspects of the disclosure provide techniques for estimating fault current resulting from the determined winding faults. Estimated fault current may be used to determine an actual effect of the detected fault on working of the electrical device and/or determining one or more corrective actions.

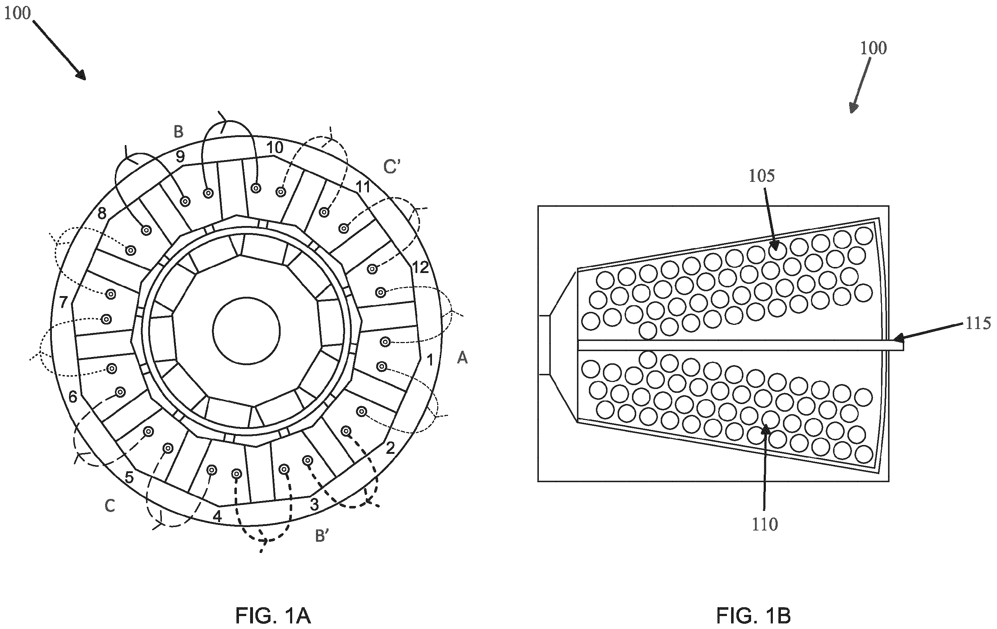

FIG. 1A is a diagram of a sectional representation of an example multi-wound electrical device (that is, a dual wound motor 100) in accordance with principles of the present disclosure. FIG. 1B is a diagram of an alternate sectional representation of dual-wound motor 100 of FIG. 1A. As illustrated in FIGS. 1A and 1B, dual-wound motor 100 includes two set of windings, for example, first set of windings 105 and a second set of windings 110. First set of windings 105 may include three windings represented as A, B, and C. Second set of windings 110 may also include three windings represented as A', B', and C'. First set of windings 105 may be separated from second set of windings 110 by a phase insulation 115. Although motor 100 is shown to include only two set of windings, motor 100 may include more than two set of windings. In addition, the techniques are being discussed with reference to motor 100, it may be applicable in any electrical device that includes more than one winding, for example, a transformer, a generator, etc.

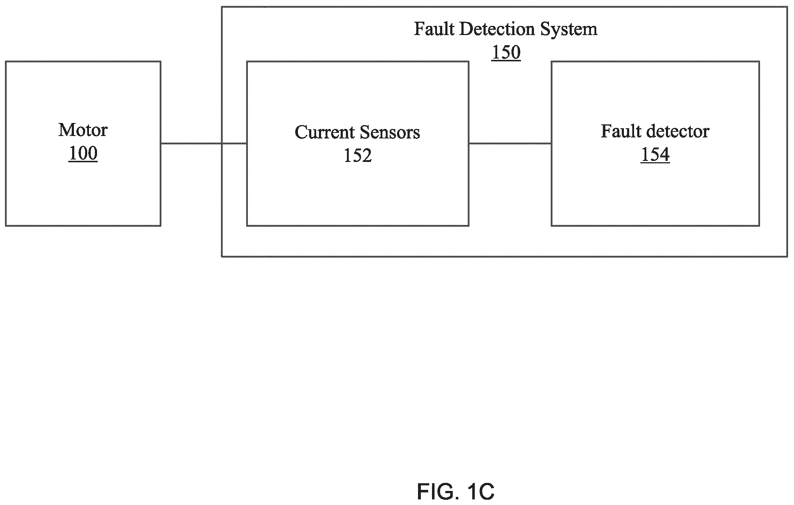

FIG. 1C is a diagram illustrating a fault detection system 150. Fault detection system 150 may detect winding faults in a multi-wound electrical device, for example, dual-wound motor 100 of FIGS. 1A and 1B. As shown in FIG. 1C, fault detection system 150 may include current sensors 152 and a fault detector 154. Current sensors 152 may be associated with each winding of motor 100 and measure an instantaneous current in the associated winding. Current sensors 152 may provide the measured current to fault detector 154. Fault detector 154 may determine, from the measured current in windings of motor 100, to determine winding faults in motor 100.

In one implementation, fault detector 154 converts measured current into a "positive sequence" (e.g., forward rotating), "negative sequence" (e.g., reverse rotating), and a "zero sequence" (e.g., common or shared) component. When a winding fault occurs in any winding of motor 100, the positive sequence component is diminished, while negative sequence and/or zero sequence components are increased. Although the presence of negative sequence and/or zero sequence components may be good indicators of a winding fault, in real-world three-phase systems are rarely (if ever) perfectly balanced. As a result, a certain amount of positive sequence and/or zero sequence components exist. Therefore, fault detector 154 may determine a baseline values for the positive sequence component, the negative sequence component, and the zero sequence component.

If motor 100 is healthy (i.e., no winding faults), the positive sequence component may dominate, and the negative and zero sequences may be negligible (that is, equal to or closer to respective baseline values). When a winding fault occurs, the positive sequence component magnitude may decrease, and the negative sequence component and/or the zero sequence component may increase. However, all windings (that is, first winding 105 and second winding 110) to motor 100 are in the same environment and load condition. Hence the sequence components of one set of windings (that is, first set of windings 105) may be compared with the sequence components of another set of windings (that is, second set of windings 110) to identify any winding fault.

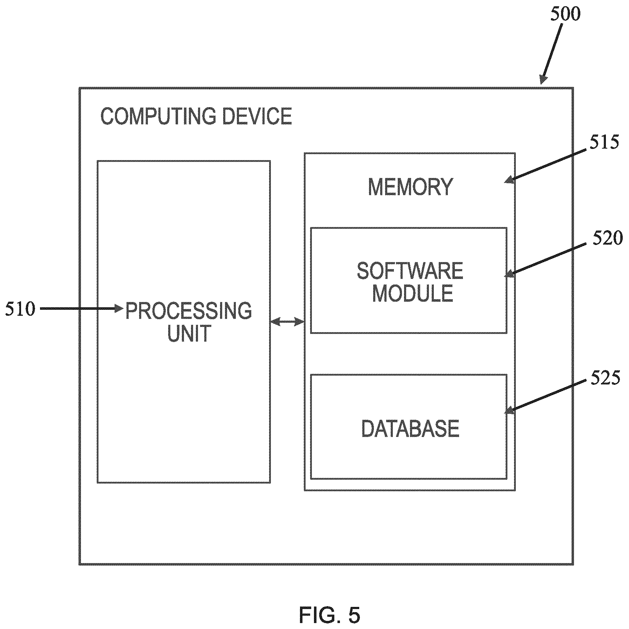

The elements described above of fault detection system 150 (that is, current sensors 152 and fault detector 154) may be practiced in a hardware and/or in software (including firmware, resident software, micro-code, etc.) or in any other circuits or systems. The elements of fault detection system 150 may be practiced in electrical circuits comprising discrete electronic elements, packaged or integrated electronic chips containing logic gates, a circuit utilizing a microprocessor, or on a single chip containing electronic elements or microprocessors. Furthermore, the elements of fault detection system 150 may also be practiced using other technologies capable of performing logical operations such as, for example, AND, OR, and NOT, including but not limited to, mechanical, optical, fluidic, and quantum technologies. As described in greater detail below with respect to FIG. 5, the elements of fault detection system 150 may be practiced in a computing device 500.

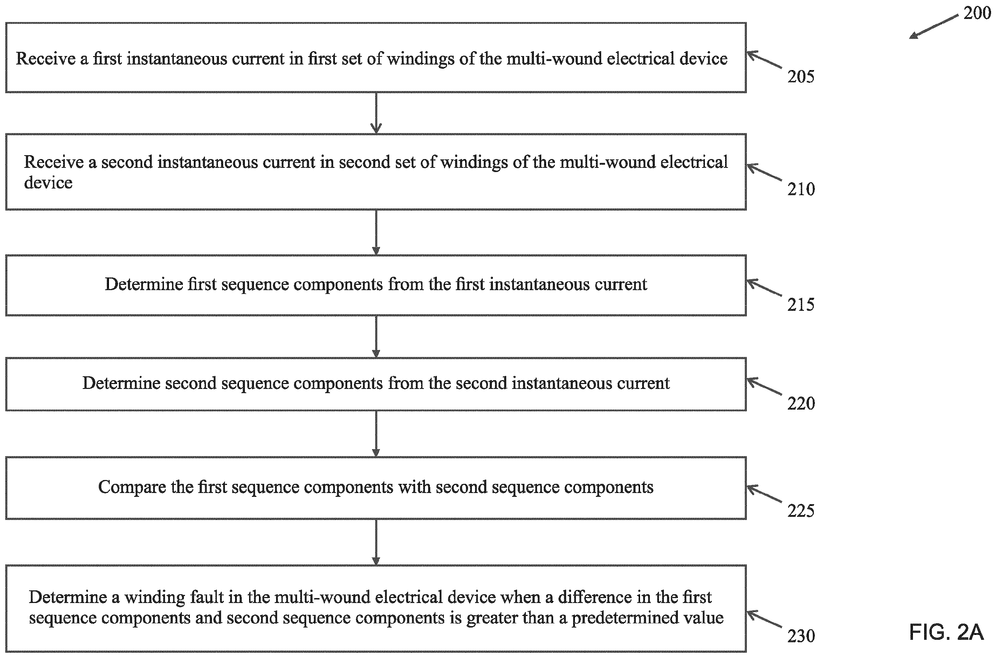

FIG. 2A is a flow diagram of a method 200 for determining a winding fault in an electrical device, for example, motor 100 described with reference to FIGS. 1A and 1B. In certain examples, method 200 can be performed by fault detector 154. In other examples, method 200 is performed by a processor connected to a memory device. The memory device may store the instructions which, when executed by the processor, perform method 200. Ways to implement the stages of method 200 will be described in greater detail below.

At stage 205 of method 200, a first instantaneous current in first set of windings of the multi-wound electrical device is received. For example, fault detector 154 may receive the first instantaneous current in first set of windings 105 of motor 100. The first instantaneous current is measured by current sensors 152 and sent to fault detector 154.

At stage 210 of method 200, a second instantaneous current in second set of windings of the multi-wound electrical device is received. For example, fault detector 154 may receive the second instantaneous current in second set of windings 110 of motor 100. The second instantaneous current is measured by current sensors 152 and sent to fault detector 154.

At stage 215 of method 200, first sequence components are determined from the first instantaneous current. For example, fault detector 154 may determine a first positive sequence component, a first negative sequence component, and a first zero sequence component from the first instantaneous current.

At stage 220 of method 200, second sequence components are determined from the second instantaneous current. For example, fault detector 154 may determine a second positive sequence component, a second negative sequence component, and a second zero sequence component from the second instantaneous current.

At stage 225 of method 200, the first sequence components are compared with second sequence components. For example, the first zero sequence is compared with the second zero sequence component. In addition, the first negative sequence is compared with the second negative component. The comparison may include determined a difference between the respective sequence components.

At stage 230 of method 200, a winding fault is determined in the multi-wound electrical device when a difference in the first sequence components and second sequence components is greater than a predetermined value. That is:

$$D = |\text{Sequence component of W1} - \text{Sequence component of W2}| > \text{Baseline} \quad (\text{Fault}).$$

$D = |\text{Sequence component of W1} - \text{Sequence component of W2}| < \text{Baseline (healthy)}.$

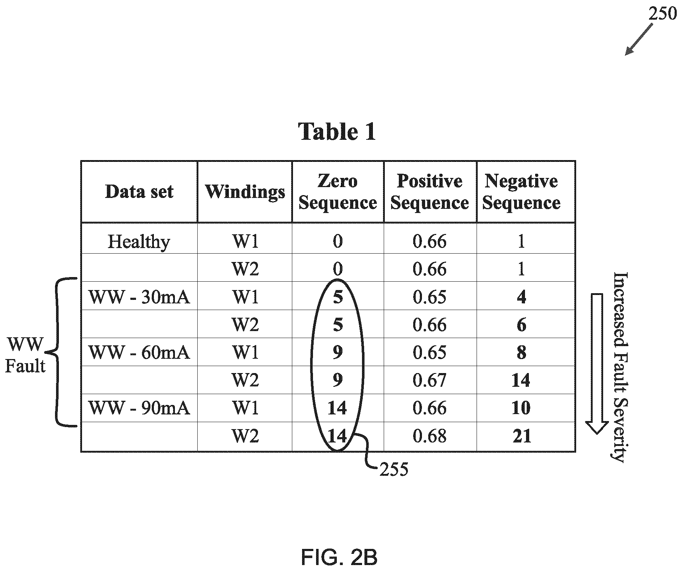

In example aspects, increase in the value of D indicates an increased fault severity. FIG. 2B is a diagram of a Table 1 illustrating first example measurements 250 corresponding to two windings of motor 100. As shown in FIG. 2B, the zero sequence component and the negative sequence component of both the winding are different from that of a healthy motor (indicated as 255). In addition, and as shown in Table 1, an increase in the difference may be indicative of increase in fault severity. As discussed in the following sections of the disclosure, a type of the winding fault (shown as a WW fault in Table 1) is also determined based on comparing the sequence components of windings of motor 100.

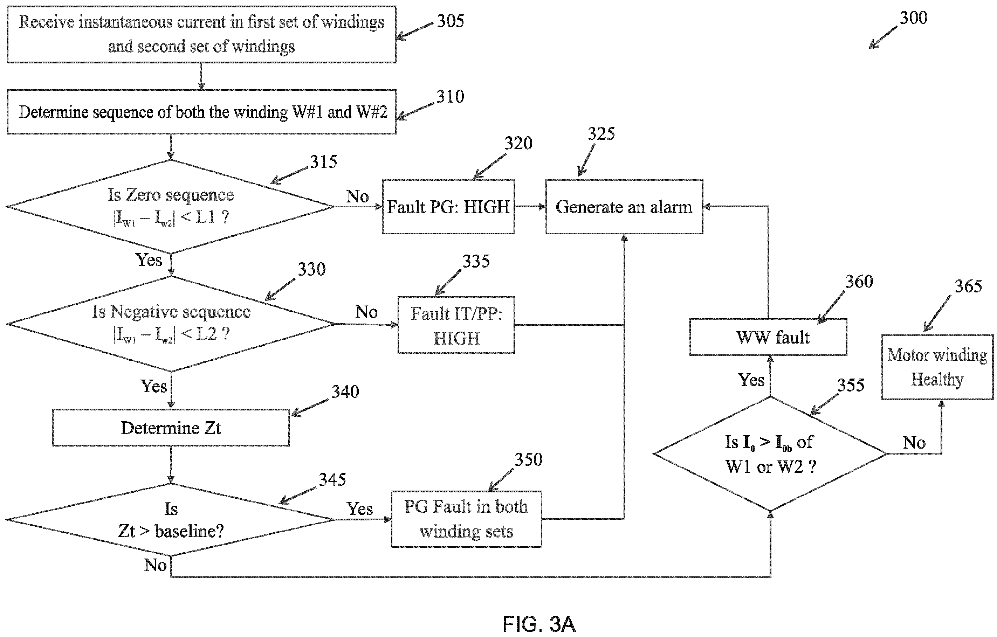

FIG. 3A is a flow diagram of a method 300 for determining a winding fault in an electrical device, for example, motor 100 described with reference to FIG. 1. In certain examples, method 300 can be performed by fault detector 154. In other examples, method 300 is performed by a processor connected to a memory device. The memory device may store the instructions which, when executed by the processor, perform method 300. Ways to implement the stages of method 300 will be described in greater detail below.

At stage 305 of method 300, instantaneous currents in each of first set of windings 105 and second set of windings 110 are received. The instantaneous currents are sensed by current sensors 152 and can be represented as $i_a$, $i_b$ and $i_c$ for first sent of windings 105 and as $i_x$, $i_y$ and $i_z$ for the second set of windings 110. The instantaneous currents are then provided to fault detector 154.

At stage 310 of method 300, sequence components are determined for the instantaneous currents for both first and second set of windings. For example, the signal components of the sensed instantaneous current can be converted into a "positive sequence" (e.g., forward rotating), "negative sequence" (e.g., reverse rotating), and a "zero sequence" (e.g., common or shared) component for both first set of windings 105 and second set of windings 110.

At stage 315 of method 300, the zero sequence component of first set of windings 105 (that is, a first zero sequence component) is compared with the zero sequence component of second set of windings 110 (that is, a second zero sequence component). During comparison it may be determined whether the difference between the first zero sequence component and the second zero sequence component is less than a first predetermined value. That is, whether:

$$|I_{W1} - I_{w2}| < L1?$$

where $I_{w1}$ represents the first zero sequence component of first set of windings 105, $I_{w2}$ represents the second zero sequence component of second set of windings 110, and L1 represents the first predetermined value. In some examples, the first predetermined value is a baseline value for the zero sequence components.

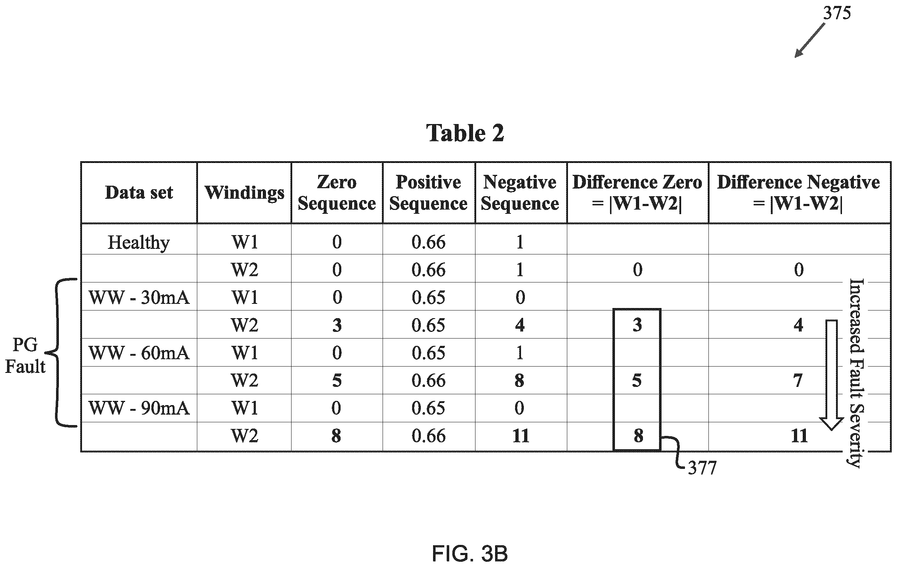

At 320 of method 300, in response to determining that the difference between the first zero sequence component and the second zero sequence component is not less than the first predetermined value at stage 315, a likelihood of a PG fault being high is determined. For example, for a healthy motor, the difference between the zero sequence components for all the windings is less than a baseline value. The zero sequence component may increase when there is a fault between a winding and the ground with a fault current flowing from the winding to the ground. FIG. 3B is a diagram of a Table 2 illustrating second example measurements 375 corresponding to a PG fault.

As shown in Table 2, for a healthy motor 110, both the first zero sequence component and the second zero sequence components are approximately equal to 0. However, and as shown in Table 2, for a leakage current of 30mA, the second zero sequence component of second set of windings 110 is 3. The leakage current is because of a winding fault, that is, a PG fault in second set of windings of motor 110. Moreover, for a leakage current of 60mA, the second zero sequence component of second set of windings 110 is 5 and increases to 8 when leakage current increases to 90mA. On the other hand, the first zero sequence component of first set of windings 105 remains approximately equal to 0 irrespective of the leakage current. Therefore, and as shown in Table 2, for a PG fault, a difference between the first zero sequence component of first set of windings 105 and the second zero sequence component of second set of windings 110 is higher than 0 (indicated as 377) and the severity increases with increase in the leakage current.

At stage 325 of method 300, an alarm is generated in response to determining the likelihood of the PG fault being high. The alarm may be an audible alarm, for example, a siren, or a visible alarm, for example, a blinking red light, or both the audible alarm and a visible alarm.

In response to determining that the difference between the first zero sequence component of first set of windings 105 and the second zero sequence component of second set of windings 110 is less than the first predetermined value at stage 315, method 300 proceeds to stage 330 where the first negative sequence component of first set of windings 105 is compared with the second negative sequence component of second set of windings 110. During the comparison, it may be determined whether the difference between the first negative sequence component and the second negative sequence component is less than a second predetermined value. That is, whether:

$$|I_{W1} - I_{w2}| < L2?,$$

where $I_{w1}$ represents the first negative sequence component of first set of windings 105, $I_{w2}$ represents the second negative sequence component of second set of windings 110, and L2 represents the second predetermined value. In some examples, the second predetermined value is a baseline value for the negative sequence components of windings of motor 100.

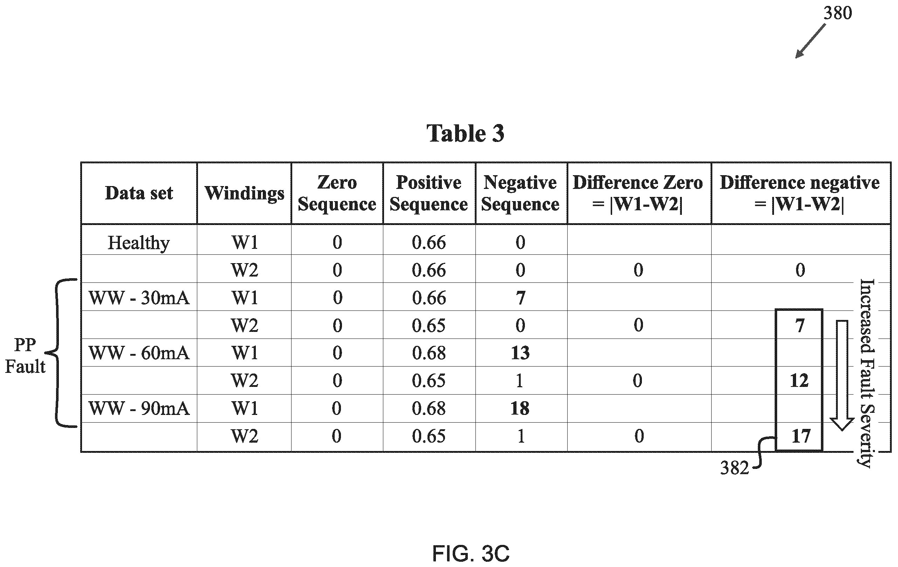

At 335 of method 300, in response to determining that the difference between the first negative sequence component and the second negative sequence component is not less than the second predetermined value, a likelihood of an IT fault and/or a PP fault being high is determined. FIG. 3C is a diagram of a Table 3 illustrating third example measurements 380 corresponding to a PP fault.

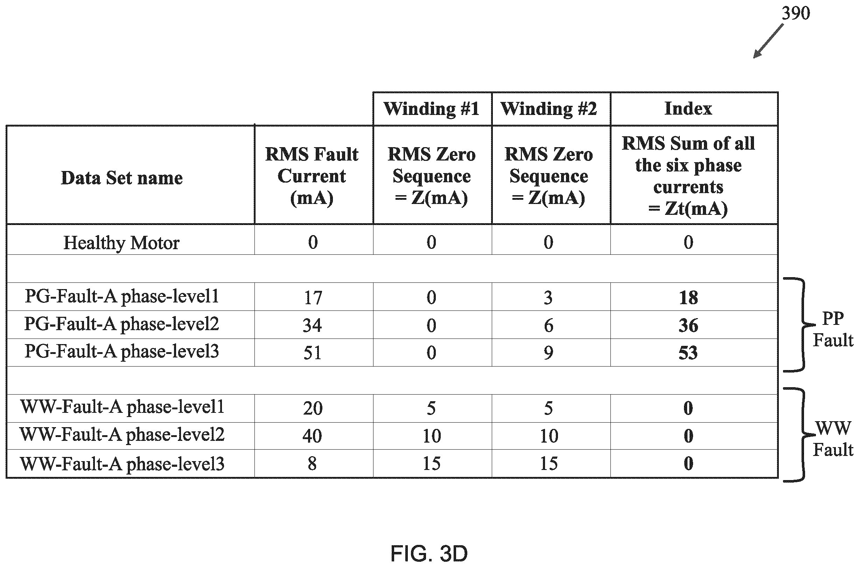

As shown in Table 3 of FIG. 3, for a healthy motor, both the first negative sequence component and the second negative component are approximately equal to 0 for both first set of windings 105 and second set of windings 110 respectively. However, and as shown in Table 3, for a leakage current of 30mA, the first negative sequence component of first set of windings 105 is at 7. The leakage current is because of a winding fault, that is, IT fault and/or a PP fault in the windings of motor 110. For example, because of a short circuit between a phase of first set of windings 105 and a phase of second set of windings, a fault current may flow between first set of windings 105 and second set of windings resulting in deviation of the negative sequence components. The increase in the fault current may result in increased deviation.

For example, and as shown in Table 3, for a leakage current of 60mA, the first negative sequence component of first set of windings 105 is 13 and increases to 18 when leakage current increases to 90mA. On the other hand, the second negative sequence component of second set of windings 110 remains approximately equal to 0 or closer to 0 (that is, 1) irrespective of the leakage current. Therefore, and as indicated in Table 3, a difference between the first negative sequence component of first set of windings 105 and the second negative sequence component of second set of windings 110 is higher than 0 and increases with increase in the leakage current (indicated as 382).

Once having determined the likelihood of the PP fault being high at stage 335, method 300 may, at stage 325, generate an alarm. The alarm can be audible alarm, a visible alarm, or a combination of both the audible and visible alarm.

In response to determining that the difference between the first negative sequence component and the second negative sequence component is less than the second predetermined value at stage 330, method 300 proceeds to stage 340 where a sum of currents for both first set of windings 105 and second set of windings 110 is determined. The sum (Zt) of currents for both first set of windings 105 and second set of windings 110 is determined is determined as:

$$Z_t = i_a + i_b + i_c + i_x + i_y + i_z$$

At stage 345 of method 300, the sum (Zt) is compared with a baseline value to determine whether the sum (Zt) is greater than the baseline value. In response to determining that the sum (Zt) is greater than the baseline value at stage 345, a likelihood of a PG fault in both first set of windings 105 and second set of windings 110 is determined at stage 350. For example, the total current of first set of windings 105 and second set of windings 110 may be more than the baseline value because of faults in both set of windings and fault currents flowing from each of first set of windings 105 and second set of windings 110 to the ground.

In response to determining that the sum (Zt) is greater than the baseline value at stage 345, an alarm is generated at stage 350 of method 300 indicating a likelihood of the PG fault in both first set of windings 105 and second set of windings 110. Once having determined the likelihood of the PG fault being high in both first set of windings 105 and second set of windings 110 at stage 350, method 300 may, at stage 325, generate an alarm. The alarm can be audible alarm, a visible alarm, or a combination of both the audible and visible alarm.

In response to determining that the sum (Zt) is not greater than the baseline value at stage 345, method 300 proceeds to stage 355 where the zero sequence component of each of first set of windings 105 and second set of windings 110 is compared with a respective baseline value. That is:

Z = |Zero Sequence component of W1/W2 - Zero Sequence component of W1/W2 of healthy system|

If a value of Z is not closer to zero (that is, when the zero sequence component of any of first set of windings 105 and second set of windings 110 is greater than the respective baseline value), then the WW fault is determined in motor 100 at stage 360. That is:

$$Z > baseline \;\&\; Z_t - Z_{t\_basline} \approx 0 \rightarrow WW \; fault.$$

$$Z > baseline \;\&\; Z_t - Z_{t\_basline} > 0 \rightarrow PG \; fault.$$

In response to determining the WW fault at stage 360, an alarm is raised at stage 325. The alarm can be audible alarm, a visible alarm, or a combination of both the audible and visible alarm.

If a value of Z is closer to zero (that is, when the zero sequence component of any of first set of windings 105 and second set of windings 110 is equal to the respective baseline value), then both first set of windings 105 and second set of windings 110 of motor 100 are determined to be healthy at stage 365.

FIG. 3D is a diagram of a Table 4 illustrating fourth example measurements 390 corresponding to a PG and a WW fault. As shown in Table 4, for a healthy motor, each of a RMS fault current, a RMS zero sequence component for first set of windings 105, a RMS zero sequence component for second set of windings 110, and a RMS sum of the six phase currents is 0. However, for a PG fault in second set of windings 110, the RMS zero sequence component of second set of windings 110 is a non-zero value and increases with increase in the fault current. In addition, for the PG fault in second set of windings 110, the sum (Zt) is also a non-zero value and increases with increase in the fault current.

In addition, and as shown in Table 4, for a WW fault, the RMS zero sequence component of both first set of windings 105 and second set of windings 110 are similar non-zero values and increase with increase in the fault current. The values may be similar because of the same fault current being present in both set of windings. In addition, for the WW fault, the sum (Zt) is approximately equal to 0 or at the baseline value.

In example aspects of the disclosure, a fault current being generated in motor 100 because of the winding faults is estimated. The fault current is estimated through modeling of the winding fault on a simulation model of motor 100. For example, a digital twin model of motor 100 is created using a simulation software (for example, Matric Library (MATLAB)/Simulink software). The twin model may include a power input, a controller, motor 100, and a load specification. The twin model is run or simulated with a loading cycle that is same as of motor 100 loading cycle. The twin model is then used to measure phase currents for healthy system condition. From the measured phase currents, the zero sequence components, the negative sequence components, and the positive sequence components are determined. In one example, the phase currents similar to the working condition of motor 100 is then provided to the twin model. Phase currents are measured for the working condition and the zero sequence components, the negative sequence components, and the positive sequence components are determined for the phase currents corresponding to the working condition. The sequence components are then compared to determine winding faults including the type of winding faults.

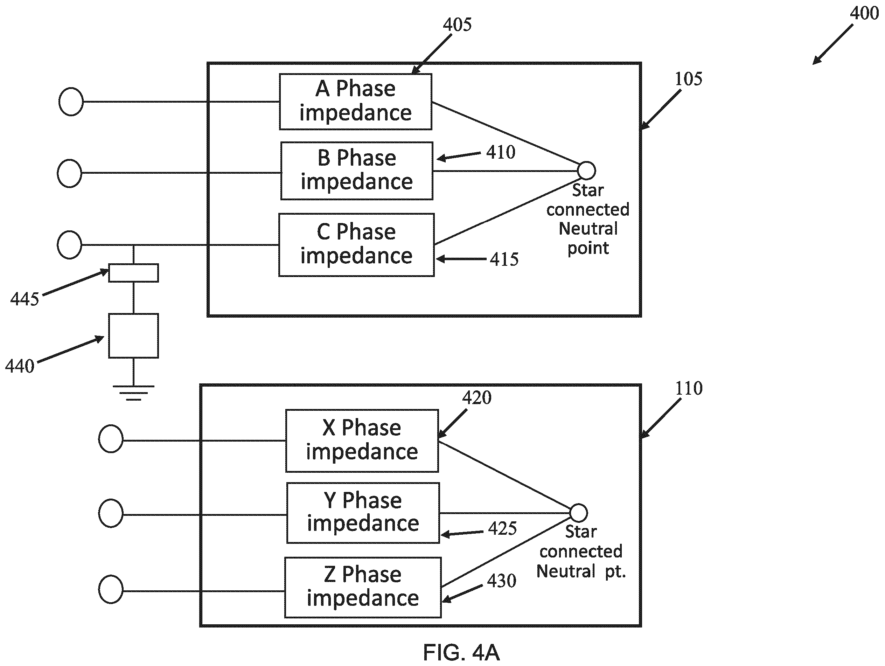

FIG. 4A illustrates a model 400 of motor 100 with a PG fault. For example, and as shown in model 400, motor 100 includes first set of windings 105 and second set of windings 110. First set of windings 105 is modeled as or includes a first phase impedance (also referred to as a A Phase impedance), a second phase impedance (also referred to as a B Phase impedance), and a third phase impedance (also referred to as a C Phase impedance). A first end of each of the A phase impedance, the B phase impedance, and the C phase impedance is connected together at a star connected neutral point.

Similarly, second set of windings 110 is modeled as or includes a fourth phase impedance (also referred to as a X Phase impedance), a fifth phase impedance (also referred to as a Y Phase impedance), and a sixth phase impedance (also referred to as a Z Phase impedance). A first end of each of the X phase impedance, the Y phase impedance, and the Z phase impedance is connected together at a star connected neutral point.

The PG fault in first set of windings 105 is modeled as a first resistor 440 between a phase (for example, a third phase) of first set of windings 105 and the ground. First resistor 440 is a variable resistor. A current sensor 445 is also included to measure an amount of current flowing through first resistor 440. Adding the variable resistor along with current sensor 445 at location shown in FIG, 4A may be treated as phase to ground fault. Under a healthy condition, there may be an infinite amount of resistance between phase-ground terminals and no leakage current flows through first resistor 440.

During simulation, a resistance value of first resistor 440 is varied to vary the leakage current. As discussed above, the sequence components are dependent on the leakage current. That is, more the value of the leakage current more is the deviation of the sequence components with respect to a healthy motor under a similar operational condition. The resistance value can be decreased gradually in model 400 to vary the sequence components. The measured sequence components (for example, the zero sequence component) derived from model 400 is continuously compared with the sequence components determined from motor 100. When a difference between the sequence components is approximately equal to or around zero, it may indicate that a PG fault like the one determined in motor 100 has been created in model 400. Measuring the current from first resistor 440 at this point provides the leakage current of motor 100 with the PG fault.

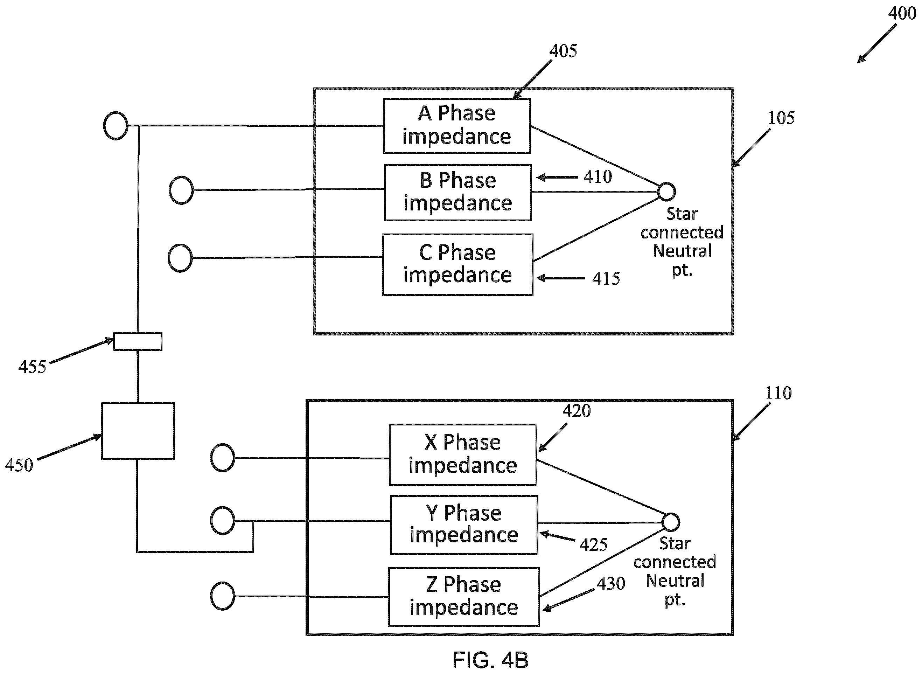

FIG. 4B illustrates model 400 of motor 100 with a WW fault. As shown in FIG. 4B, a second resistor 450 is connected between A phase impedance 405 of first set of windings 105 and the Y phase impedance 425 of second set of windings 110. Second resistor 450 is also a variable resistor. A current sensor 455 is also included to measure an amount of current flowing through second resistor 450. Adding the variable resistor along with current sensor 455 at a location shown in Fig. 4B may be treated as a WW fault. Under a healthy condition, there may be an infinite resistance between winding-winding terminals and no leakage current flows between the windings.

The resistance value of second resistor 455 is decreased gradually in model 400. Winding currents are measured for each resistance value and sequence components are determined for each measured winding currents. The sequence components derived from model 400 are measured with the sequence components determined from motor 100. When a difference between the sequence components derived from model 400 and the sequence components determined from motor 100 is approximately equal to or around zero, it may indicate that a WW fault has been created in model 400. The current flowing through second resistor 450 is measured which is representative of the leakage current of motor 100.

The estimated fault current may be used to determine a corrective action to be performed in response to determining a winding fault in motor 100. For example, if the estimated fault current is within a predetermined value and is not increasing with time, no corrective action may be recommended. However, in response to determining that the estimated fault current is not within a predetermined value and/or is increasing with time, one or more corrective actions may be recommended. The corrective actions may include, for example, shifting load from faulty winding set, decreasing a load on motor 100, shutting down motor 100, etc.

In some examples, for known load profiles, first set of windings 105 may draw a first power (P1) and second set of windings 110 may draw a second power (P2). In an unknown fault condition, a difference between the first power (P1) and second power (P2) (that is, (|P1-P2|)) is around zero or some known value. If there is a winding fault, then the fault current may dissipate power in form of heat. In addition, due to the winding fault, the faulty winding set may draw more power from the supply resulting in an increase in a value of |P1-P2| with respect to a healthy motor 100. Higher the power loss, higher is the fault severity, higher is the flow of leakage current and higher will be the hotspot temperature. The simulation in model 400 may estimate this rise in temperature value based on the power loss |P1-P2| value. Determining the rise in the temperature may help determining a remaining useful life of the winding insulation. This may provide an estimate of the remaining useful life of motor 100.

In examples, the processes or methods disclosed herein may be applicable to any multi-phase systems having six, nine or higher number of phases. In addition, the methods disclosed herein may be applicable to motors, generators, transformers, multi phases power cables, transmission lines, etc.

FIG. 5 shows computing device 500. As shown in FIG. 5, computing device 500 may include a processing unit 510 and a memory unit 515. Memory unit 515 may include a software module 520 and a database 525. While executing on processing unit 510, software module 520 may perform, for example, processes for determining winding faults as described above with respect to FIGS. 2A-3D. Computing device 500, for example, may provide an operating environment for current sensors 152 and fault detector 154. Current sensor 152 and fault detector 154 may operate in other environments and are not limited to computing device 500.

Computing device 500 may be implemented using, a tablet device, a mobile device, a smart phone, a telephone, a remote control device, a cable modem, a personal computer, a network computer, a mainframe, a router, a switch, a server cluster, a smart TV-like device, a network storage device, a network relay device, or other similar microcomputer-based device. Computing device 500 may comprise any computer operating environment, such as hand-held devices, multiprocessor systems, microprocessor-based or programmable sender electronic devices, minicomputers, mainframe computers, and the like. Computing device 500 may also be practiced in distributed computing environments where tasks are performed by remote processing devices. The aforementioned systems and devices are examples, and computing device 500 may comprise other systems or devices.

Embodiments of the disclosure, for example, may be implemented as a computer process (method), a computing system, or as an article of manufacture, such as a computer program product or computer readable media. The computer program product may be a computer storage media readable by a computer system and encoding a computer program of instructions for executing a computer process. The computer program product may also be a propagated signal on a carrier readable by a computing system and encoding a computer program of instructions for executing a computer process. Accordingly, the present disclosure may be embodied in hardware and/or in software (including firmware, resident software, micro-code, etc.). In other words, embodiments of the present disclosure may take the form of a computer program product on a computer-usable or computer-readable storage medium having computer-usable or computer-readable program code embodied in the medium for use by or in connection with an instruction execution system. A computer-usable or computer-readable medium may be any medium that can contain, store, communicate, propagate, or transport the program for use by or in connection with the instruction execution system, apparatus, or device.

The computer-usable or computer-readable medium may be, for example but not limited to, an electronic, magnetic, optical, electromagnetic, infrared, or semiconductor system, apparatus, device, or propagation medium. More specific computer-readable medium examples (a non-exhaustive list), the computer-readable medium may include the following: an electrical connection having one or more wires, a portable computer diskette, a random access memory (RAM), a read-only memory (ROM), an erasable programmable read-only memory (EPROM or Flash memory), an optical fiber, and a portable compact disc read-only memory (CD-ROM). Note that the computer-usable or computer-readable medium could even be paper or another suitable medium upon which the program is printed, as the program can be electronically captured, via, for instance, optical scanning of the paper or other medium, then compiled, interpreted, or otherwise processed in a suitable manner, if necessary, and then stored in a computer memory.

While certain embodiments of the disclosure have been described, other embodiments may exist. Furthermore, although embodiments of the present disclosure have been described as being associated with data stored in memory and other storage mediums, data can also be stored on, or read from other types of computer-readable media, such as secondary storage devices, like hard disks, a carrier wave from the Internet, or other forms of RAM or ROM. Further, the disclosed methods' stages may be modified in any manner, including by reordering stages and/or inserting or deleting stages, without departing from the disclosure.

Furthermore, embodiments of the disclosure may be practiced in an electrical circuit comprising discrete electronic elements, packaged or integrated electronic chips containing logic gates, a circuit utilizing a microprocessor, or on a single chip containing electronic elements or microprocessors. Embodiments of the disclosure may also be practiced using other technologies capable of performing logical operations such as, for example, AND, OR, and NOT, including but not limited to, mechanical, optical, fluidic, and quantum technologies. In addition, embodiments of the disclosure may be practiced within a general purpose computer or in any other circuits or systems.

Embodiments of the disclosure may be practiced via a system-on-a-chip (SOC) where each or many of the element illustrated in FIG. 2 may be integrated onto a single integrated circuit. Such an SOC device may include one or more processing units, graphics units, communications units, system virtualization units and various application functionality all of which may be integrated (or "burned") onto the chip substrate as a single integrated circuit. When operating via an SOC, the functionality described herein with respect to embodiments of the disclosure, may be performed via application-specific logic integrated with other components of computing device 500 on the single integrated circuit (chip).

Embodiments of the present disclosure, for example, are described above with reference to block diagrams and/or operational illustrations of methods, systems, and computer program products according to embodiments of the disclosure. The functions/acts noted in the blocks may occur out of the order as shown in any flowchart. For example, two blocks shown in succession may in fact be executed substantially concurrently or the blocks may sometimes be executed in the reverse order, depending upon the functionality/acts involved.

While the specification includes examples, the disclosure's scope is indicated by the following claims. Furthermore, while the specification has been described in language specific to structural features and/or methodological acts, the claims are not limited to the features or acts described above. Rather, the specific features and acts described above are disclosed as example for embodiments of the disclosure.

## Claims

1.    A method for determining a winding fault in a multi-wound electrical device, the method comprising:

>     receiving a first instantaneous current in first set of windings of the multi-wound electrical device;
>     receiving a second instantaneous current in second set of windings of the multi-wound electrical device;
>     determining first sequence components from the first instantaneous current;
>     determining second sequence components from the second instantaneous current;
>     comparing the first sequence components with second sequence components;
>     determining a winding fault in the multi-wound electrical device when a difference in the first sequence components and second sequence components is greater than a predetermined value.

2.    The method of claim 1, further comprising:

>     creating a twin model of the electrical device;
>     modeling the winding fault in the twin model, wherein the winding fault is modeled as a resistor;
>     determining first model sequence components for the first set of windings from the twin model;
>     determining second model sequence components for the second instantaneous current from the twin model;
>     comparing the first model sequence components with the first sequence
>     components;
>     comparing the second model sequence components with the second sequence components; and
>     varying a resistance value of the resistor until the first model sequence components match with the first sequence components and the second model sequence components match with the second sequence components.

3.    The method of claim 1, wherein comparing the first sequence components with the second sequence components comprises:
>     comparing a first zero sequence component of the first sequence components with a second zero sequence component of the second sequence components.

4.    The method of claim 3, further comprising:
>     determining a phase-to-ground fault in at least one of the first set of windings and the second set of windings in response to determining that a difference between the first zero sequence component of the first sequence components and the second zero sequence component of the second sequence components is not less than a first predetermined value.

5.    The method of claim 4, further comprising:
>     generating an alarm in response to determining the phase-to-ground fault.

6.    The method of claim 4, further comprising:
>     comparing a first negative sequence component of the first sequence components with a second negative component of the second sequence components in response to determining that the difference between the first zero sequence component of the first sequence components and the second zero second component of the second sequence components is less than the first predetermined value.

7. The method of claim 6, further comprising:
determining a phase-to-phase fault in response to determining that a difference between the first negative sequence component of the first sequence components and the second negative sequence component of the second sequence components is not less than a second predetermined value.

8. The method of claim 6, further comprising:
determining a sum of first currents of first set of windings and second currents of second set of windings in response to determining that a difference between the first negative sequence component of the first sequence components and the second negative sequence component of the second sequence components is less than the second predetermined value.

9. The method of claim 8, further comprising:
determining a phase-to-ground fault in both the first set of windings and the second set of windings in response to determining that the sum of first currents of first set of windings and second currents of second set of windings is greater than a third predetermined value.

10. The method of claim 8, further comprising:
determining whether the first zero sequence component or the second zero sequence component is greater than a respective baseline value in response to determining that the sum of first currents of first set of windings and second currents of second set of windings is not greater than the third predetermined value.

11. The method of claim 10, further comprising:
determining both the first set of windings and the second set of windings to be healthy in response to determining that none of the first zero sequence component or the second zero sequence component is greater than the respective baseline value.

12. The method of claim 10, further comprising:
determining a winding-to-winding fault in response to determining that both the first zero sequence component and the second zero sequence component is greater than the respective baseline value.

13. The method of claim 1, further comprising:

modeling a phase to ground fault as a first resistor connected between the ground and a phase of one of the first set of windings and the second set of windings.
modeling a winding to winding fault as a second resistor connected between a phase of the first set of windings and a phase of the second set of windings.

14. The method of claim 1, further comprising:
modeling the winding fault to determine a fault current caused by the winding fault.

15. A system for determining a winding fault in a multi-wound electrical device, the system comprising:

a memory that stores a set of instructions; and
a processor connected to the memory, wherein the processor is configured to execute the set of instructions which when executed perform the method of any of the preceding claims.

FIG. 1B

FIG. 1A

FIG. 1C

FIG. 2A

250

## Table 1

| Data set | Windings | Zero Sequence | Positive Sequence | Negative Sequence |
|---|---|---|---|---|
| Healthy | W1 | 0 | 0.66 | 1 |
| | W2 | 0 | 0.66 | 1 |
| WW - 30mA | W1 | **5** | 0.65 | **4** |
| | W2 | **5** | 0.66 | **6** |
| WW - 60mA | W1 | **9** | 0.65 | **8** |
| | W2 | **9** | 0.67 | **14** |
| WW - 90mA | W1 | **14** | 0.66 | **10** |
| | W2 | **14** | 0.68 | **21** |

WW Fault

Increased Fault Severity

255

FIG. 2B

FIG. 3A

EP 4 664 127 A1

## Table 2

| Data set | Windings | Zero Sequence | Positive Sequence | Negative Sequence | Difference Zero = \|W1-W2\| | Difference Negative = \|W1-W2\| |
|---|---|---|---|---|---|---|
| Healthy | W1 | 0 | 0.66 | 1 | | |
| | W2 | 0 | 0.66 | 1 | 0 | 0 |
| WW - 30mA | W1 | 0 | 0.65 | 0 | | |
| | W2 | 3 | 0.65 | 4 | 3 | 4 |
| WW - 60mA | W1 | 0 | 0.65 | 1 | | |
| | W2 | 5 | 0.66 | 8 | 5 | 7 |
| WW - 90mA | W1 | 0 | 0.65 | 0 | | |
| | W2 | 8 | 0.66 | 11 | 8 | 11 |

FIG. 3B

## Table 3

| Data set | Windings | Zero Sequence | Positive Sequence | Negative Sequence | Difference Zero = \|W1-W2\| | Difference negative = \|W1-W2\| |
|---|---|---|---|---|---|---|
| Healthy | W1 | 0 | 0.66 | 0 | | |
| | W2 | 0 | 0.66 | 0 | 0 | 0 |
| WW - 30mA | W1 | 0 | 0.66 | 7 | | |
| | W2 | 0 | 0.65 | 0 | 0 | 7 |
| WW - 60mA | W1 | 0 | 0.68 | 13 | | |
| | W2 | 0 | 0.65 | 1 | 0 | 12 |
| WW - 90mA | W1 | 0 | 0.68 | 18 | | |
| | W2 | 0 | 0.65 | 1 | 0 | 17 |

380

PP Fault

Increased Fault Severity

382

FIG. 3C

EP 4 664 127 A1

EP 4 664 127 A1

| Data Set name | RMS Fault Current (mA) | Winding #1 RMS Zero Sequence = Z(mA) | Winding #2 RMS Zero Sequence = Z(mA) | Index RMS Sum of all the six phase currents = Zt(mA) | |
|---|---|---|---|---|---|
| Healthy Motor | 0 | 0 | 0 | 0 | |
| | | | | | |
| PG-Fault-A phase-level1 | 17 | 0 | 3 | **18** | PP Fault |
| PG-Fault-A phase-level2 | 34 | 0 | 6 | **36** | |
| PG-Fault-A phase-level3 | 51 | 0 | 9 | **53** | |
| | | | | | |
| WW-Fault-A phase-level1 | 20 | 5 | 5 | **0** | WW Fault |
| WW-Fault-A phase-level2 | 40 | 10 | 10 | **0** | |
| WW-Fault-A phase-level3 | 8 | 15 | 15 | **0** | |

FIG. 3D

FIG. 4A

FIG. 4B

COMPUTING DEVICE

PROCESSING
UNIT

510

MEMORY

515

SOFTWARE
MODULE

520

DATABASE

525

500

FIG. 5

Europäisches
Patentamt
European
Patent Office
Office européen
des brevets

## EUROPEAN SEARCH REPORT

**Application Number**

EP 25 18 1743

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 4 199 346 A1 (EATON INTELLIGENT POWER LTD [IE]) 21 June 2023 (2023-06-21)<br>* figures 1-8 *<br>* paragraph [0009] - paragraph [0081] *<br>* claim 1 *<br>----- | 1-15 | INV.<br>G01R31/34<br>G01R31/52<br>G01R31/72 |
| A | US 2023/396204 A1 (ZUO YING [CA] ET AL) 7 December 2023 (2023-12-07)<br>* figures 1-10 *<br>* paragraph [0011] - paragraph [0091] *<br>----- | 1-15 | |

**TECHNICAL FIELDS SEARCHED (IPC)**

G01R

The present search report has been drawn up for all claims

| Place of search | Date of completion of the search | Examiner |
|---|---|---|
| Munich | 14 October 2025 | Sedlmaier, Stefan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 18 1743

This annex lists the patent family members relating to the patent documents cited in the above-mentioned European search report.
The members are as contained in the European Patent Office EDP file on
The European Patent Office is in no way liable for these particulars which are merely given for the purpose of information.

14-10-2025

| Patent document cited in search report | | | Publication date | Patent family member(s) | | Publication date |
|---|---|---|---|---|---|---|
| EP 4199346 | A1 | | 21-06-2023 | NONE | | |
| US 2023396204 | A1 | | 07-12-2023 | CA | 3192703 A1 | 05-05-2022 |
| | | | | CN | 116507929 A | 28-07-2023 |
| | | | | EP | 4196808 A1 | 21-06-2023 |
| | | | | KR | 20230096030 A | 29-06-2023 |
| | | | | US | 2023396204 A1 | 07-12-2023 |
| | | | | WO | 2022087726 A1 | 05-05-2022 |

EPO FORM P0459

For more details about this annex : see Official Journal of the European Patent Office, No. 12/82

**REFERENCES CITED IN THE DESCRIPTION**

**Patent documents cited in the description**

- IN 202411044635